# EUROPÄISCHE PATENTSCHRIFT

(11) **EP 1 953 881 B1**
(45) Veröffentlichungstag und Bekanntmachung des Hinweises auf die Patenterteilung: **12.05.2010**
(21) Anmeldenummer: 08000993.9
(22) Anmeldetag: 18.08.2005
(51) Int. Cl.: H01S 5/40, H04N 9/31

(54) **Laservorrichtung zur Erzeugung eines Laserstrahls**
Laser device for creating a laser beam
Dispositif à laser destiné à la production d'un rayon laser

(30) Priorität: 18.08.2004 DE 202004013003 U; 08.03.2005 DE 202005003856 U; 13.06.2005 DE 202005009294 U
(43) Veröffentlichungstag der Anmeldung: 06.08.2008
(62) Teilanmeldung aus: 05783434.3
(73) Patentinhaber: Arctos Showlasertechnik e.K., 83416 Saaldorf-Surheim (DE)
(72) Erfinder: Hafner, Thomas, 83416 Saaldorf-Surheim (DE)
(74) Vertreter: Hofmann, Matthias

(56) Entgegenhaltungen:
- WO-A-03/098758
- DE-A1- 10 113 019
- DE-U1-202004 013 003
- US-A- 6 005 717
- US-A- 6 028 722

## Beschreibung

Die Erfindung betrifft Vorrichtungen zur Erzeugung eines Laserstrahls mit guter Sichtbarkeit und hoher Energiedichte.

Im Stand der Technik sind so genannte DPSS-Laser bekannt, die einen hohen Energieverbrauch aufweisen. Diese Laser haben ein Strahlungsmaximum bei einer Wellenlänge von ca. 671 Nanometern. Diese Wellenlänge befindet sich nahe am Infrarotbereich des Lichtspektrums und ist für das menschliche Auge nur schwer wahrnehmbar. Um mit einem solchen Laser mit dem Auge sichtbares Licht in ausreichender Stärke zu erzeugen, sind hohe Leistungen nötig. Die US 6 687 271 veranschaulicht, wie man einen solchen Laser mit hoher Leistungsdichte betreiben kann.

In "Heterostructure Lasers" (H.C. Casey, Jr., M.B. Panish, , Academic Press 1978, ISBN 0-12-163102-8 (pt. B), S. 43-44) werden Systeme zur Beschreibung der Farbeigenschaften von Halbleitern angegeben.

In der DE 41 28 966 A1 werden Messungen von orthogonalen Bewegungskomponenten mittels Doppler-Velocimetrie beschrieben.

Die WO 2004/112209 A1 zeigt eine Vorrichtung, mit der der Abstand von Strahlenfächern von Laserdioden verringert werden kann.

In "Laser-Licht in Diskotheken" (K. Nowak in "der elektromeister + deutsches elektrohandwerk" 12/80, S. 883-886) werden Laseranwendungen in Ligh-Shows beschrieben. Eine Weiterentwick-lung einer solchen Laser-Show ist in der DE 42 22 951 A1 gezeigt.

Die DE 200 10 309 U1, die WO 03/098758 A1 und die WO 98/13910 beschreiben Diodenlaseranordnungen, mit der die Laserstrahlen aus mehreren Diodenlasern koaxial überlagert werden können.

In der US 5 463 534, in der US 5 668 903, in der US 6 732 929 B2, in der US 6 240 116 B1 und in der DE 196 03 111 A1 werden optische Systeme zur Erzeugung einer Lichtquelle beschrieben, bei denen mehrere Laserstrahlen kombiniert werden.

Das Markieren bzw. Bearbeiten einer Oberfläche mittels Laserstrahlen ist in der DE 195 11 393 A1, in der DE 298 16 107 U1 und in der DE 198 40 926 A1 beschrieben. Die DE 198 41 040 A1 zeigt eine solche Vorrichtung zum Markieren einer Oberfläche mittels Laserstrahlen, bei der charakteristische Eigenschaften eines Laserstrahls verändert und das damit erzeugte Strahlungsfeld homogenisiert wird.

Die US 6 388 799 zeigt eine optische Vorrichtung, bei der die Phase zwischen zwei Signalen unterschiedlicher Frequenz verbessert wird, und zwar abhängig von der Helligkeit eines verbundenen Lichtstrahls.

Die WO 2003/098758 A1 zeigt eine Vorrichtung zur Überlagerung der Ausgabe nebeneinander angeordneter Laserdioden, die jeweils Licht mit gleicher Polarisationsorientierung emittieren.

Die DE 101 13 019 A1 zeigt eine Anordnung zur Einkopplung eines Lichtstrahls in eine Lichtleitfaser, bei der ein Polarisationsdrehelement zum Einsatz kommt.

Bei den im Stand der Technik bekannten Systemen ist von Nachteil, dass weisses Laserlicht nur sehr aufwendig und teuer erzeugbar ist. Kleinlaser lassen sich nicht gut bereitstellen, diese fallen mit der bekannten Technik sehr gross aus . Die Erfindung geht von der Aufgabe aus, einen Laser bereitzustellen, der einen gut sichtbaren Strahl erzeugt, wobei nur wenig Energie verbraucht werden soll.

Diese Aufgabe wird gemäss der Erfindung durch den Gegenstand des unabhängigen Patentanspruchs gelöst. Vorteilhafte Weiterbildungen ergeben sich aus den jeweiligen abhängigen Patentansprüchen.

Eine erste Laserteilstrahleinrichtung dient zur Erzeugung eines roten Laserstrahls, eine zweite Laserteilstrahleinrichtung dient zur Erzeugung eines cyanfarbenen Laserstrahls mit einer grünen Laserdiode zur Erzeugung eines grünen Laserstrahls und mit einer blauvioletten Laserdiode blauvioletten Laserstrahls. Die Laservorrichtung ist weiterhin so ist, dass der grüne Laserstrahls, der blauviolette Laserstrahls und der rote Laserstrahl zu einem weißen Laserstrahl überlagert zusammengeführt werden.

Eine erste Sammeleinheit dient zur Zusammenführung des grünen Laserstrahls und des blauvioletten Laserstrahls zu einem cyanfarbenen Laserstrahl und eine zweite Sammeleinheit dient zur Zusammenführung des roten Laserstrahls und des cyanfarbenen Laserstrahls zu einem weissen Laserstrahl.

Die Laserdioden sind als Halbleiter-Laserdioden ausgebildet, deren Substrat die Elemente P, In, Ga und/oder A1 aufweist und die Licht mit einer Wellenlänge von ca. 652 nm bis ca. 664 nm, vorzugsweise ca. 654 nm bis ca. 662 nm und vorzugsweise mit einem Maximum bei ca. 658 nm erzeugen. Die blauvioletten Laserdioden sind als Halbleiter-Laserdioden ausgebildet, die Licht mit einer Wellenlänge von ca. 401 um bis ca. 439 nm, vorzugsweise ca. 401 nm bis ca. 415 nm und vorzugsweise mit einem Maximum bei ca. 408 nm erzeugen.

Die grünen Laserdioden sind als Halbleiter-Laserdioden ausgebildet, die Licht mit einer Wellenlänge von ca. 505 nm bis ca. 555 nm, vorzugsweise ca. 520 nm bis ca. 544 nm und vorzugsweise mit einem Maximum bei ca. 532 nm erzeugen.

Die erfindungsgemäße Laservorrichtung zur Erzeugung eines Laserstrahls kann noch eine zweite Laserteilstrahleinrichtung zur Erzeugung eines cyanfarbenen Laserstrahls mit einer grünen Laserdiode zur Erzeugung eines grünen Laserstrahls und mit einer blauvioletten Laserdiode zur Erzeugung eines blauvioletten Laserstrahls aufweisen. Die Laservorrichtung kann dabei so ausgebildet sein, dass der grüne Laserstrahls und der blauviolette Laserstrahls zu einem blauen Laserstrahl überlagert zusammengeführt sind.

Die Erfindung kann für zahlreiche Lichtfarben eingesetzt werden, nicht nur für rote Laserstrahlen sondern auch für blaue Laserstrahlen. So lassen sich einerseits die Leistungen von mehreren Laserdioden zusammenführen, um eine höhere Ausgangsleistung zu erzielen. Gleichzeitig ergibt sich aufgrund der Polarisierungsrichtungen ein guter Gesamteffekt und ein einfacher Aufbau sowie eine leichte Einstellbarkeit der Vorrichtung.

Die Laserdioden zur Erzeugung roter Lichtstrahlen sind dabei vorzugsweise als Halbleiter-Laserdioden ausgebildet, deren Substrat die Elemente Phosphor, Indium, Gallium und/oder Aluminium aufweist. Solche Laserdioden erzeugen Licht mit einer Wellenlänge von ca. 630 (in besonderen Fällen 652) Nanometer bis ca. 690 (in besonderen Fällen 664) Nanometer, und zwar vorzugsweise mit einem Leistungsmaximum bei ca. 658 Nanometer Wellenlänge. Es hat sich bewährt, dabei Laserdioden auszuwählen, die ein Leistungsmaximum in einem Wellenlängenbereich von ca. 654 Nanometer bis ca. 662 Nanometer haben. Die Emittergröße sollte nicht größer als 2 x 20 Mikrometer haben, welche mit nachgeschalteter 20 mm-Linse zur Bündelung/Parallelisierung dieses Emitters ausgestattet ist. Bei größeren Laserdioden-Emittern wird die Strahlqualität im Endresultat unnötig verschlechtert.

Die Laserdioden zur Erzeugung blauvioletter Lichtstrahlen sind dabei vorzugsweise als Halbleiter-Laserdioden ausgebildet. Solche Laserdioden erzeugen Licht mit einer Wellenlänge von ca. 399 (in besonderen Fällen 408) Nanometer bis ca. 415 (in besonderen Fällen 440) Nanometer, und zwar vorzugsweise mit einem Leistungsmaximum bei ca. 408 Nanometer Wellenlänge. Es hat sich bewährt, dabei Laserdioden auszuwählen, die ein Leistungsmaximum in einem Wellenlängenbereich von etwas kleiner als 440 Nanometer haben. Die Emittergröße sollte nicht größer als 2 x 20 Mikrometer haben, welche mit nachgeschalteter 20 mm-Linse zur Bündelung/Parallelisierung dieses Emitters ausgestattet ist. Bei größeren Laserdioden-Emittern wird die Strahlqualität im Endresultat unnötig verschlechtert.

Die vorstehenden blauvioletten Laserdioden ergeben dabei beim Zusammenmischen mit etwas Licht aus einer grünen Laserdiode von ca. 532 nm (auch mit "grün" aus einem Bereich um diesen Wert herum, beispielsweise 505 nm bis 555 nm) gut sichtbare Blautöne. Dies ist ein überraschender Effekt, denn es ist nicht zu erwarten gewesen, dass bereits ein ganz geringer Anteil von etwa 3% bis 10% der Leistung im grünen Spektralbereich zusammen mit 90% bis 97% der Leistung im schlecht sichtbaren violetten Bereich eine relativ hohe Lichtleistung im gut sichtbaren blauen Spektralbereich ergibt, allerdings mit einem deutlichen Blaustich. Beim Zumischen von höheren Lichtleistungen im grünen Spektralbereich wird die Farbe des sich ergebenden Lichts zunehmend grüner.

Weisslicht-Balance ergibt sich beispielsweise bei ca. 80mW grünem Licht (ca. 532 nm) und bei ca. 150mW blauviolettem Licht (ca. 408 nm), gemischt mit ca. 270 mW rotem Licht (650 nm). Somit ergibt sich eine Gesamtleistung von ca. 500 mW, gemessen mit einem Halbleiter-Laser-Leistungsmessgerät.

Häufig erzeugen solche Laserdioden einen Laserstrahl mit einem im Wesentlichen elliptischen oder nahezu rechteckigen Querschnitt, wobei ein solcher Laserstrahl eine Polarisierung überwiegend in Richtung der längeren Symmetrieachse der Ellipse bzw. des Rechtecks aufweist. Hierbei ist zu beachten, dass mit der Bezeichnung "Querschnitt" nicht gemeint ist, dass ein Lichtstrahl einen fest umgrenzten Querschnitt wie etwa denjenigen eines Stabes aufweist. Vielmehr ist es so, dass der Querschnitt eines solchen Laserstrahls sich aus denjenigen Orten innerhalb des Laserstrahls bestimmt, die in etwa eine gleiche Leistungsdichte aufweisen.

Die Erfindung lässt es zu, besonders kostengünstige und klein bauende Laser herzustellen. Die hierfür verwendeten Laserdioden haben Ausgangsleistungen von ca. 200 mW, gemessen mit einem Halbleiter-Laser-Leistungsmessgerät. Durch Verwendung einer blauvioletten Laserdiode, einem Klein-DPSS-Grünlaser und einem Rotlicht-Mischlaser ist es möglich, einen Laser der Laserklase 4 mit einer Leistung von mehr als 500 mW herzustellen, dessen Baugröße der Größe einer Handfläche entspricht.

Es hat sich bewährt, die Sammeleinheit als Polarisationswürfel auszubilden, der vorzugsweise aus BK7-Glas nach Grade A hergestellt ist, und zwar mit einer entsprechenden zur Wellenlänge aufgedampften Antireflex-Beschichtung. Solche Polarisationswürfel werden häufig als Strahlteiler eingesetzt, um einen Laserstrahl in zwei Bestandteile mit zueinander senkrechter Polarisation zu zerlegen.

Die Spiegel-Kollimatoreinheit weist nach der Erfindung eine Linseneinheit auf, deren eingangsseitige Brennweite größer als die ausgangsseitige Brennweite ist. Eine solche Linseneinheit wird häufig auch als "achromatic doublets" bezeichnet. Es können hierfür aber auch geringwertigere Linsen eingesetzt werden.

Der erfindungsgemäße Laser wird insbesondere zur Projektion in einem Dreifarblaser eingesetzt, der für Beamshows dient. Dabei wird der rote Strahl zur Ergänzung der Palette Rot-Grün-Blau der bereits vorhandenen Laser Grün-Blau verwendet.

Wenn die horizontale Lasereinrichtungen bzw. die horizontalen Lasereinrichtungen je wenigstens zwei nebeneinander angeordnete Laserdioden zur Ausgabe eines horizontalen Quadratlaserstrahls aufweist, wobei die Sammeleinheit zur Zusammenführung des horizontalen Quadratlaserstrahls und des vertikalen Laserstrahls zum ersten Laserstrahl bzw. zum zweiten Laserstrahl vorgesehen ist, dann ergeben sich größere Strahlquerschnitte oder höhere Energiedichten, je nachdem, wie die einzelnen Strahlengänge gelegt werden. Dabei können die vertikale Lasereinrichtung bzw. die vertikale Lasereinrichtungen je wenigstens zwei nebeneinander angeordneten Laserdioden zur Ausgabe eines vertikalen Quadratlaserstrahl und eine Sammeleinheit zur Zusammenführung des vertikalen Quadratlaserstrahls und des horizontalen Laserstrahls und des vertikalen Laserstrahls zum ersten Laserstrahl bzw. zum zweiten Laserstrahl aufweisen.

In einer weiteren Ausgestaltung können ein oder mehrere Spiegel zur im wesentlichen parallelen Zusammenführung und Ausgabe des ersten Laserstrahls und des zweiten Laserstrahls als Ausgabelaserstrahl vorgesehen sein. Zudem kann zur leichteren Einstellung dieser Spiegel je eine Teillasergruppe auf einer Teillaser-Verstelleinrichtung angeordnet sein, mit der deren Laserdioden und der Sammeleinheit gemeinsam bezüglich der übrigen Komponenten der Vorrichtung verschiebbar bzw. verdrehbar sind. Weiter können die horizontale und/oder die vertikale Lasereinrichtung auf je einer Dioden-Verstelleinrichtung angeordnet ist, mit der deren Laserdioden gemeinsam bezüglich den übrigen Komponenten der Vorrichtung verschiebbar bzw. verdrehbar sind.

Besonders kompakt wird der Aufbau, wenn die erste Laserteilstrahleinrichtung und die zweite Laserteilstrahleinrichtung je zwei horizontale Lasereinrichtungen und zwei vertikale Lasereinrichtungen mit je zwei nebeneinander angeordneten Laserdioden zur Ausgabe eines horizontalen Quadratlaserstrahls bzw. eines vertikalen Quadratlaserstrahls aufweisen, wobei je eine horizontale Lasereinrichtung und eine vertikale Lasereinrichtung mit je zwei nebeneinander angeordneten Laserdioden zu einer Teillasergruppe angeordnet sind. Bei roten Laserstrahlen sollten die Laserdioden als Halbleiter-Laserdioden ausgebildet sein, deren Substrat die Elemente P, In, Ga und/oder A1 aufweist und die Licht mit einer Wellenlänge von ca. 652 nm bis ca. 664 im, vorzugsweise ca. 654 nm bis ca. 662 nm und vorzugsweise mit einem Maximum bei ca. 658 nm erzeugen. Solche Laserdioden emittieren häufig einen Laserstrahl mit einem im wesentlichen elliptischen und nahezu rechteckigen Querschnitt, wobei der Laserstrahl eine Polarisierung überwiegend in Richtung der längeren Symmetrieachse der Ellipse bzw. des Rechtecks aufweist.

Die Sammeleinheit wird als Polarisationswürfel ausgebildet ist, der vorzugsweise aus BK7-Glas nach Grade A hergestellt ist und die Kollimatoreinheit hat einen Kollimator mit einer Linseneinheit, deren eingangsseitige Brennweite größer als die ausgangsseitige Brennweite ist.

Eine Disco-Projektionseinrichtung hat eine solche Vorrichtung nach eine zum Erzeugen eines Laserstrahls, bei der der Laserstrahl (26) auf einem wenigstens teilweise reflektierenden Gegenstand oder auf Rauch- oder Nebelpartikel auftrifft. Solche Disco-Projektionseinrichtung werden häufig zur entgeltlichen Unterhaltung von Publikum eingesetzt.

Die Erfindung sieht in einer besonders vorteilhaften Ausführungsform eine Vorrichtung vor, die eine erste Laserteilstrahleinrichtung zur Erzeugung eines ersten Laserstrahls und eine zweite Laserteilstrahleinrichtung zur Erzeugung eines zweiten Laserstrahls aufweist. Der erste Laserstrahl und der zweite Laserstrahl werden dabei zusammengeführt, so dass sie im Wesentlichen parallel übereinander und/oder nebeneinander liegen und so einen Ausgabelaserstrahl bilden. Zum Zusammenführen wird eine Spiegeleinheit verwendet, wobei eine besondere Kollimatoreinheit für eine Parallelisierung der mit einem Spiegel übereinander gelegten Laserstrahlen sorgt. Die erste Laserstrahleinrichtung und die zweite Laserstrahleinrichtung weisen dabei eine horizontale und eine vertikale Lasereinrichtung mit zwei nebeneinander angeordneten Laserdioden auf. Die Bezeichnungen "horizontal" und "vertikal" beziehen sich hier und nachfolgend jeweils auf die Polarisierung eines damit erzeugten Laserstrahls. Dabei erzeugen die horizontalen Laserdioden einen horizontalen Quadratlaserstrahl und die vertikalen Laserdioden erzeugen einen vertikalen Quadratlaserstrahl.

Weiterhin ist darin eine Sammeleinheit, die insbesondere als Polarisationswürfel ausgebildet ist, zum Zusammenführen des horizontalen Quadratlaserstrahls und des vertikalen Quadratlaserstrahls zum ersten Laserstrahl bzw. zum zweiten Laserstrahl vorgesehen. Mit einer solchen Einrichtung lassen sich auf besonders einfache Weise Laserstrahlen mit hoher Energiedichte erzeugen. Dabei ist durch das Übereinanderlegen von horizontal polarisierten und von vertikal polarisierten Lasterstrahlen gewährleistet, dass der sich ergebende Laserstrahl keine oder nur eine geringe überwiegende Polarisation in einer bestimmten Richtung aufweist. Ungeachtet der Polarisation kann der erfindungsgemäße Laserstrahl für mit dem menschlichen Auge sichtbare Anwendungen, beispielsweise in der Werbung, in der Animation oder in der gewerblichen Projektion von Filmen und anderen Bildern eingesetzt werden. Immer mehr werden solche Anwendungen gefordert, bei denen ein erfindungsgemäßer Laserstrahl auf einen wenigstens teilweise reflektierenden Gegenstand oder auch auf Rauch- oder Nebelpartikel geworfen wird. Die erste Laserteilstrahleinrichtung und die zweite Laserteilstrahleinrichtung können dabei je eine horizontale Lasereinrichtung und je eine vertikale Lasereinrichtung mit je zwei nebeneinander angeordneten Laserdioden zur Ausgabe eines horizontalen Quadratlaserstrahls bzw. eines vertikalen Quadratlaserstrahl aufweisen. Dabei können die horizontale Lasereinrichtung und die vertikale Lasereinrichtung auch voneinander getrennt sein, so dass in der ersten Laserteilstrahleinrichtung nur horizontale Lasereinrichtungen und in der zweiten Laserteilstrahleinrichtung nur vertikale Lasereinrichtungen vorgesehen sind, oder umgekehrt.

Es kann je eine Sammeleinheit zur Zusammenführung des horizontalen Quadratlaserstrahls und des vertikalen Quadratlaserstrahls zum ersten Laserstrahl bzw. zum zweiten Laserstrahl vorgesehen sein. Die erste Laserteilstrahleinrichtung und die zweite Laserteilstrahleinrichtung können auch eine gemeinsame Sammeleinheit benutzen, ohne dass sie sich gegenseitig beeinflussen, wenn diese unterschiedlich polarisiert sind. Dann wirkt die Verwendung einer einzigen Sammeleinheit von der Funktion her wie die Verwendung je einer Sammeleinheit.

Die Erfindung stellt eine Vorrichtung zur Erzeugung eines roten Laserstrahls mit hoher Energiedichte und kleinem Öffnungswinkel (Divergenz) bei gleichzeitig hohem Wirkungsgrad des Systems bereit. Das erste Laserstrahlprofil und das zweite Laserstrahlprofil werden dabei zusammengeführt.

In einer besonders vorteilhaften Ausgestaltung mit einem Laserstrahl mit besonders großer Querschnittsfläche weist die erste Laserteilstrahleinrichtung und die zweite Laserteilstrahleinrichtung je zwei horizontale und zwei vertikale Lasereinrichtungen mit je zwei nebeneinander angeordneten Laserdioden auf. Je eine horizontale und eine vertikale Lasereinrichtung sind dabei zu einer Teillasergruppe im Sinne der Erfindung angeordnet.

Eine besonders einfache Verstellbarkeit der Komponenten der erfindungsgemäßen Laservorrichtung ergibt sich dann, wenn je eine Teillasergruppe auf einer Teillaser-Verstelleinrichtung angeordnet ist, mit der deren Komponenten gemeinsam bezüglich der übrigen Komponenten der Vorrichtung verschiebbar bzw. verdrehbar sind. Dasselbe gilt, wenn die horizontale oder die vertikale Lasereinrichtung auf je einer einzeln einstellbaren Dioden-Verstelleinrichtung angeordnet ist.

Die Laserdioden sind dabei vorzugsweise als Halbleiter-Laserdioden ausgebildet, deren Substrat die Elemente Phosphor, Indium, Gallium und/oder Aluminium aufweist. Solche Laserdioden erzeugen Licht mit einer Wellenlänge von ca. 630 (in besonderen Fällen 652) Nanometer bis ca. 690 (in besonderen Fällen 664) Nanometer, und zwar vorzugsweise mit einem Leistungsmaximum bei ca. 658 Nanometer Wellenlänge. Es hat sich bewährt, dabei Laserdioden auszuwählen, die ein Leistungsmaximum in einem Wellenlängenbereich von ca. 654 Nanometer bis ca. 662 Nanometer haben. Die Emittergrösse sollte nicht größer als 2 x 20 Mikrometer haben, welche mit nachgeschalteter 20 mm-Linse zur Bündelung/Parallelisierung dieses Emitters ausgestattet ist. Bei größeren Laserdioden-Emittern wird die Strahlqualität im Endresultat unnötig verschlechtert.

Häufig erzeugen solche Laserdioden einen Laserstrahl mit einem im Wesentlichen elliptischen oder nahezu rechteckigen Querschnitt, wobei ein solcher Laserstrahl eine Polarisierung überwiegend in Richtung der längeren Symmetrieachse der Ellipse bzw. des Rechtecks aufweist. Hierbei ist zu beachten, dass mit der Bezeichnung "Querschnitt" nicht gemeint ist, dass ein Lichtstrahl einen fest umgrenzten Querschnitt wie etwa denjenigen eines Stabes aufweist. Vielmehr ist es so, dass der Querschnitt eines solchen Laserstrahls sich aus denjenigen Orten innerhalb des Laserstrahls bestimmt, die in etwa eine gleiche Leistungsdichte aufweisen.

Es hat sich bewährt, die Sammeleinheit als Polarisationswürfel auszubilden, der vorzugsweise aus BK7-Glas nach Grade A hergestellt ist, und zwar mit einer entsprechenden zur Wellenlänge aufgedampften Antireflex-Beschichtung. Solche Polarisationswürfel werden häufig als Strahlteuer eingesetzt, um einen Laserstrahl in zwei Bestandteile mit zueinander senkrechter Polarisation zu zerlegen.

Die Spiegel-Kollimatoreinheit weist nach der Erfindung eine Linseneinheit auf, deren eingangsseitige Brennweite größer als die ausgangsseitige Brennweite ist. Eine solche Linseneinheit wird häufig auch als "achromatic doublets" bezeichnet. Es können hierfür aber auch geringwertigere Linsen eingesetzt werden.

Der erfindungsgemäße Laser wird insbesondere zur Projektion in einem Dreifarblaser eingesetzt, der für Beamshows dient. Dabei wird der rote Strahl zur Ergänzung der Palette Rot-Grün-Blau der bereits vorhandenen Laser Grün-Blau verwendet.

Die Erfindung ist nachfolgend mit mehreren Figuren näher veranschaulicht.
- Figur 1: zeigt eine schematische Darstellung einer erfindungsgemäßen Laservorrichtung in der Draufsicht,
- Figur 2: zeigt eine schematische Darstellung einer weiteren erfindungsgemäßen Laservorrichtung,
- Figur 3: zeigt eine schematische Darstellung einer weiteren erfindungsgemäßen Laservorrichtung,

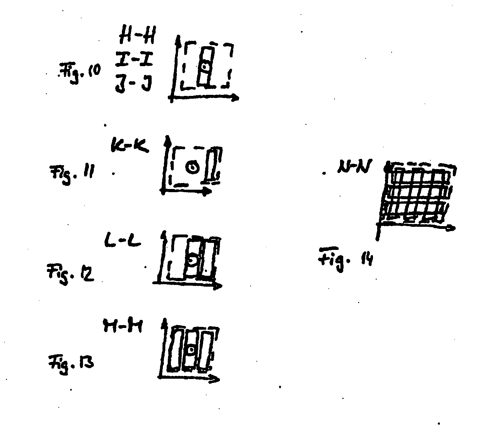

- Figur 4-14: zeigen Querschnitte von Laserteilstrahlen der Laservorrichtung aus Figur 3,
- Figur 15: zeigt eine schematische Darstellung einer weiteren erfindungsgemäßen Laservorrichtung, und

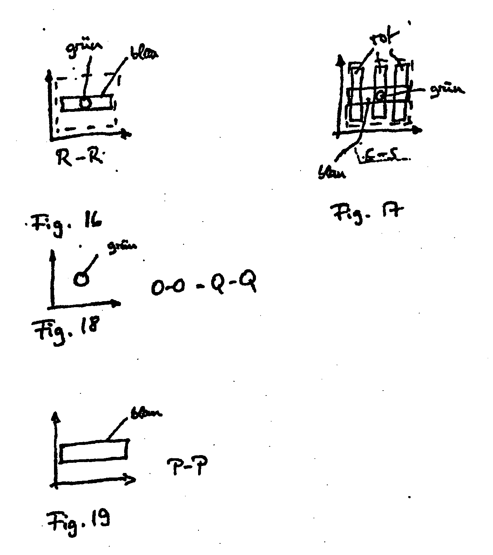

- Figur 16-19: zeigen Querschnitte von Laserteilstrahlen der Laservorrichtung aus Figur 15.

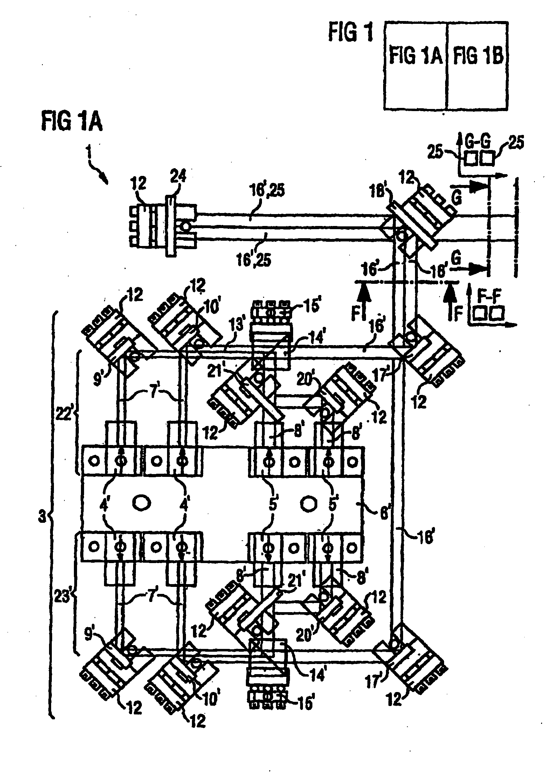

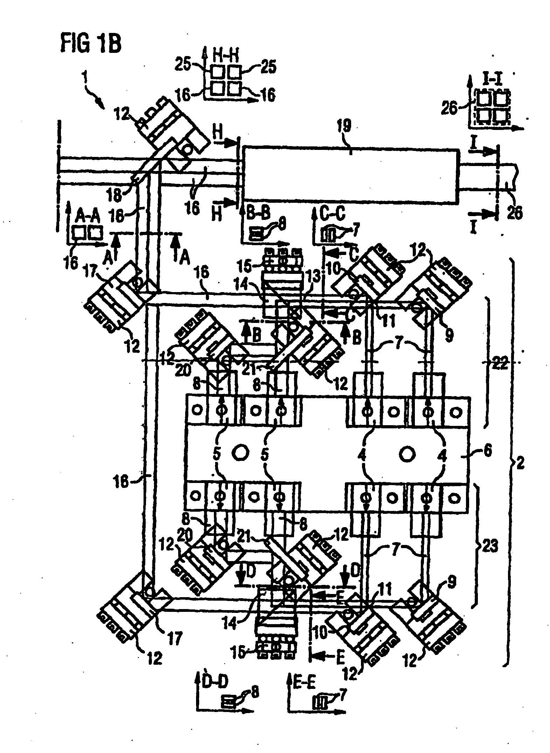

Figur 1 zeigt eine schematische Darstellung einer erfindungsgemäßen Laservorrichtung 1 in der Draufsicht.

Die Laservorrichtung 1 gliedert sich in eine erste Laserteilstrahleinrichtung 2 sowie in eine zweite Laserteilstrahleinrichtung 3. Die erste Laserteilstrahleinrichtung 2 und die zweite Laserteilstrahleinrichtung 3 sind zueinander achsensymmetrisch, d. h. spiegelbildlich ausgebildet. Im Weiteren werden nur die Komponenten der ersten Laserteilstrahleinrichtung 2 beschrieben. Komponenten der zweiten Laserteilstrahleinrichtung, die denjenigen der ersten Laserteilstrahleinrichtung 2 entsprechen, haben dieselben Bezugsziffern, werden jedoch mit einem Apostroph versehen. Zur besseren Verständlichkeit werden sowohl die erste Laserteilstrahleinrichtung 2 als auch die zweite Laserteilstrahleinrichtung 3 verkürzt mit "die Laserteilstrahleinrichtung" bezeichnet. Das Herzstück einer Laserteilstrahleinrichtung sind vier vertikal polarisierte Laserdioden 4 und vier horizontal polarisierte Laserdioden 5, die auf einem gemeinsamen Support 6 angeordnet sind. Die Laserdioden 5, 6 sind handelsübliche Halbleiterdioden, die einen mikroskopisch kleinen Querschnitt von ca. 1 x 20 Mikrometer in der aktiven Zone aufweisen. Sie weisen eine für Laserdioden typische divergente Strahlkeule mit elliptischem Querschnitt und gasförmige Intensitätsverteilung auf. Im vorliegenden Fall emittieren diese roten Laser mit nachgeschaltetem Kollimator Licht im sichtbaren Bereich des Lichtspektrums . In Figur 1 wird dem Umstand, dass die Laserdioden 4, 5 einen Lichtstrahl mit elliptischem Querschnitt emittieren, dadurch Rechnung getragen, dass die von den vertikal polarisierten Laserdioden 4 imitierten vertikalen Lichtstrahlen 7 in der Draufsicht schmaler gezeichnet sind als die von den horizontal polarisierten Laserdioden 5 imitierten horizontalen Lichtstrahlen 8. Im Bereich vor den vertikal polarisierten Laserdioden 4 ist dabei ein erster Vertikalspiegel 9 und ein zweiter Vertikalspiegel 10 vorgesehen, die die beiden entsprechenden vertikalen Lichtstrahlen 7 um einen Winkel von 90° umlenken. Dabei ist der zweite Vertikalspiegel 10 gerade um einen solchen Betrag verschoben angeordnet, dass dessen zu den vertikal polarisierten Laserdioden 4 hin gerichtete Vorderkante 11 gerade den zweiten vertikalen Lichtstrahl 7 vorbeistreichen lässt. Zur Aufnahme des ersten Vertikalspiegels 9 und des zweiten Vertikalspiegels 10 sowie zur einfacheren Verstellung in den drei Raumrichtungen sind Spiegelhalter 12 vorgesehen, die auch für alle übrigen Spiegel der Laservorrichtung 1 verwendet werden.

Durch die besondere Anordnung der beiden vertikal polarisierten Laserdioden 4 im Zusammenhang mit dem ersten Vertikalspiegel 9 und dem zweiten Vertikalspiegel 10 entsteht dadurch ein vertikaler Quadratlaserstrahl 13, dessen Querschnitt in der Schnittzeichnung C-C als Summe der Querschnitte der beiden vertikalen Lichtstrahlen 7 veranschaulicht ist. Der vertikale Quadratlaserstrahl 13 wird in einen Polarisationswürfel 14 eingespeist, der auf einem Polarisationswürfelhalter 15 angebracht ist. Der vertikale Quadratlaserstrahl 13 durchtritt den Polarisationswürfel 14 und tritt dort als erster Laserstrahl 16 aus. Er trifft in der Folge auf den ersten Umlenkspiegel 17 und nachfolgend auf den zweiten Umlenkspiegel 18. Durch den zweiten Umlenkspiegel 18 wird der erste Laserstrahl 16 in einen Kollimator 19 reflektiert. Dort wird der erste Laserstrahl 16 zu einem parallelen Strahlenbündel umgewandelt, sofern er noch divergente Strahlungsanteile aufweist. Beim Eintritt in den Kollimator 19 hat der erste Laserstrahl 16 einen im Wesentlichen quadratischen Querschnitt, der sich aus dem Umriss der vertikalen Lichtstrahlen 7 ergibt. Der Querschnitt des ersten Laserstrahls 16 ist dabei in der Querschnittszeichnung A-A veranschaulicht.

Im Wesentlichen auf dieselbe Weise werden die horizontalen Lichtstrahlen 8 aus den horizontal polarisierten Laserdioden 5 in den ersten Laserstrahl 16 eingekoppelt. Hierzu ist nach der in Figur 1 linksseitig gezeigten horizontal polarisierten Laserdiode 5 ein erster Horizontalspiegel 20 vorgesehen, der den entsprechenden horizontalen Lichtstrahl 8 um 90° umlenkt. Danach ist ein zweiter Horizontalspiegel 21 vorgesehen, der den horizontalen Lichtstrahl 8 in den Polarisationswürfel 14 umlenkt. Der zweite Horizontalspiegel 21 ist dabei so tief angeordnet, dass seine obere. Seite unterhalb desjenigen horizontalen Lichtstrahls 8 liegt, der aus der in Figur 1 rechts gelegenen horizontal polarisierten Laserdiode 5 austritt. Der horizontale Lichtstrahl 8, der aus der in Figur 1 rechts gelegenen horizontal polarisierten Laserdiode 5 austritt, streicht gerade oberhalb des zweiten Horizontalspiegels 21 entlang vorbei und tritt in den Polarisationswürfel 14 ein. Der Querschnitt B-B veranschaulicht dabei die Lage der beiden horizontalen Lichtstrahlen 8 kurz vor dem Eintritt in den Polarisationswürfel 14.

Die in Figur 1 rechts oben gelegenen vertikal polarisierten Laserdioden 4 und horizontal polarisierten Laserdioden 5 bilden dabei eine erste Teillasergruppe 22. Achsensymmetrisch bzw. spiegelbildlich dazu ist eine zweite Teillasergruppe 23 aus dem in Figur 1 untenseitig gelegenen vertikal polarisierten Laserdioden 4 und horizontal polarisierten Laserdioden 5 gebildet. Der von dieser zweiten Teillasergruppe 23 erzeugte erste Laserstrahl 16 wird durch den ersten Umlenkspiegel 17 so auf den zweiten Umlenkspiegel 18 gelenkt, dass dieser gerade an dem ersten Umlenkspiegel 17 der ersten Teillasergruppe 22 vorbeistreicht. Die Querschnitte der Lichtstrahlen der zweiten Teillasergruppe 23 sind in Querschnittszeichnungen E-D und E-E veranschaulicht.

Der Strahlengang in der zweiten Laserteilstrahleinrichtung 3 entspricht im Wesentlichen demjenigen in der ersten Laserteilstrahleinrichtung 2. Allerdings ist es so, dass die auf dem zweiten Umlenkspiegel 18' auftreffenden ersten Laserstrahl 16' zu einem in Figur 1 links oben gelegenen Höhenanpassspiegel 24 umgeleitet werden, den diese als zweiter Laserstrahl 25 verlassen. Die Stellung des Höhenanpassspiegels 24 ist so gewählt, dass der zweite Laserstrahl 25 gerade über den zweiten Umlenkspiegel 18' hinwegstreicht, bevor der zweite Laserstrahl 25 in den Kollimator 19 eintritt. Der zweite Umlenkspiegel 18' ist dabei gerade so hoch ausgebildet, dass der vom ersten Umlenkspiegel 17 ' herrührende erste Laserstrahl 16 ' gerade noch auf den Höhenanpassspiegel 24 gelenkt werden kann, wobei der vom Höhenanpassspiegel 24 ausgehende zweite Laserstrahl 25 gerade über den zweiten Umlenkspiegel 18' hinwegstreicht. Die Querschnitte G-G und H-H veranschaulichen dies.

Der Kollimator 19 transformiert dabei die insgesamt divergente Laserdiodenstrahlung aus dem ersten Laserstrahl 16 und dem zweiten Laserstrahl 25 zu einem parallelen Strahlenbündel in Form eines roten Laserstrahls 26. Der Querschnitt I-I in Figur 1 verdeutlicht dies.

Die erste Laserstrahleinrichtung und die zweite Laserstrahleinrichtung kann dabei in einem hier nicht gezeigten Ausführungsbeispiel auch noch mehrere, nebeneinander angeordnete Laserdioden aufweisen, z. B. drei Stück.

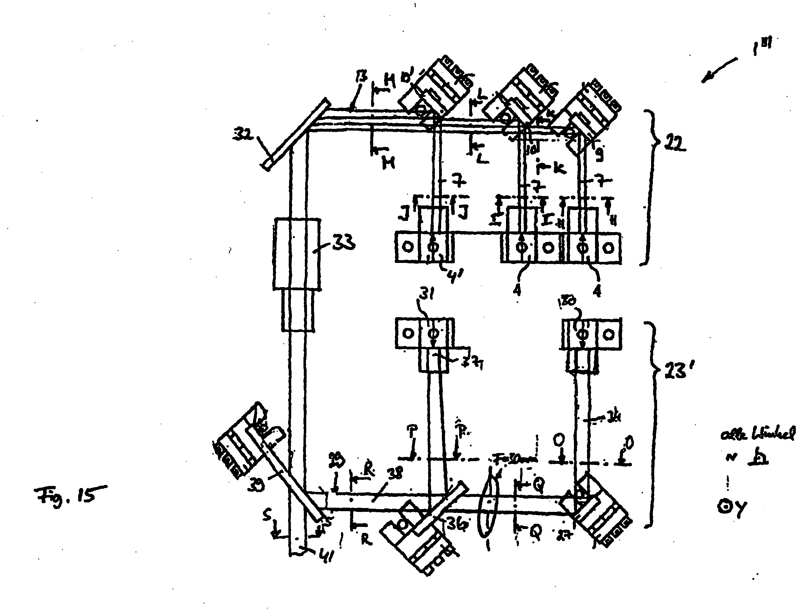

Die Erfindung kann natürlich auch dafür eingesetzt werden, um Licht aus Laserdioden mit anderen Wellenlängen zu vervielfachen. Dann werden Laserdioden mit entsprechend anderer Wellenlänge eingesetzt. So können die Laserdioden einer Polarisierungsrichtung aus einem Spektralbereich gewählt werden und die Laserdioden der anderen Polarisierungsrichtung aus einem Spektralbereich, wie dies untenstehend in Figur 15 gezeigt ist.

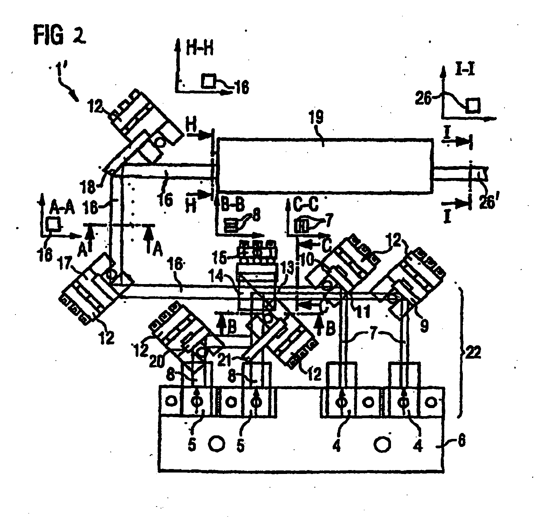

Die Laserdioden werden so optimiert, dass sich eine hohe Abgabeleistung bei gleichzeitig guter Sichtbarkeit für das menschliche Auge ergibt. Figur 2 zeigt eine Schematische Darstellung einer weiteren erfindungsgemäßen Laservorrichtung 1' in der Draufsicht. Die Bauteile der Laservorrichtung 1' entsprechen im wesentliche denen in der Figur 1. Gleiche Bauteile haben dieselben Bezugsziffern.

Figur 2 veranschaulicht, wie man die Laservorrichtung 1 vereinfachen kann. Dadurch ergibt sich ein dünnerer roter Laserstrahl 26' als der entsprechende rote Laserstrahl 26 in Figur 1.

Will man die Laservorrichtung 1' noch einfacher gestalten, dann lässt man die beiden Spiegel 17, 18 weg. Man ordnet dann den Kollimator 9 unmittelbar hinter dem Polwürfel 14 an, und zwar so, dass der aus dem Polwürfel 14 austretende erste Laserstrahl 16 im Eintrittsende des Kollimators 19 eintritt.

In einer Abwandlung der Laservorrichtung 1' nach Figur 2 befinden sich auf dem gemeinsamen Support 6 genau zwei polarisierende Laserdioden, und zwar eine vertikal polarisierende Laserdiode 4 und eine horizontal polarisierende Laserdiode 5. Der von der vertikal polarisierenden Laserdiode erzeugte Lichtstrahl 7 und der von der horizontal polarisierenden Laserdiode 5 erzeugte Lichtstrahl 8 werden wie in Figur 2 zusammengeführt, dann umgelenkt und in den Kolliminator 19 reflektiert. Die beschriebene Laservorrichtung 1' kann um einen weiteren Support 6 mit ebenfalls zwei Laserdioden, wovon eine horizontal und eine vertikal polarisiert, und mit einer Sammeleinrichtung erweitert werden.

In einer weiteren Abwandlung enthält die Laservorrichtung 1 ' genau drei vertikal polarisierende Laserdioden. Dabei sind mindestens eine vertikal polarisierende Laserdiode 4 und mindestens eine horizontal polarisierende Laserdiode 5 vorhanden. Die dritte Laserdiode ist entweder vertikal oder horizontal polarisierend. Die zwei gleichartig polarisierenden Laserdioden sind nebeneinander angeordnet.

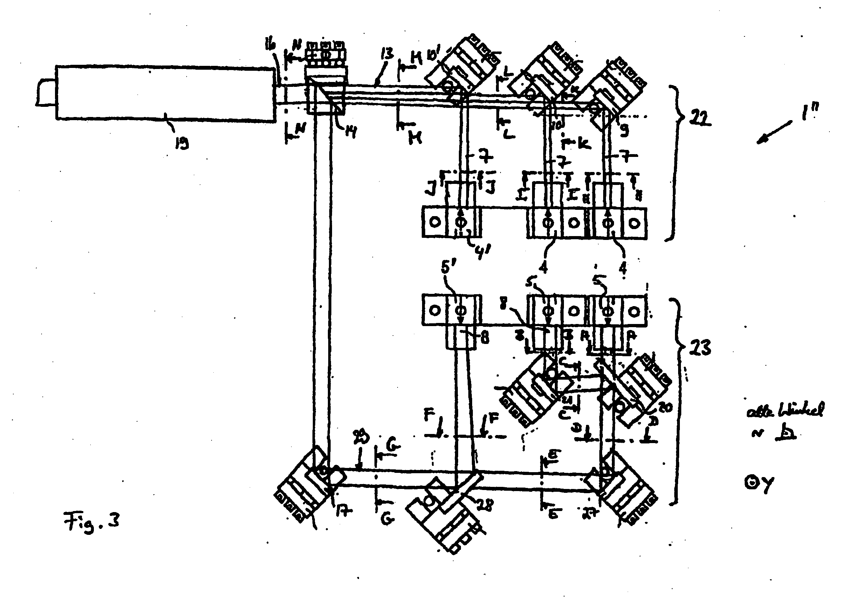

Figur 3 zeigt eine schematische Darstellung einer Laservorrichtung 1' ' in der Draufsicht. Die Bauteile der Laservorrichtung 1' ' entsprechen im wesentliche denen in der Figur 1. Gleiche Bauteile haben dieselben Bezugsziffern.

Die Laservorrichtung 1'' gliedert sich in eine erste Laserteilstrahleinrichtung 22 sowie in eine zweite Laserteilstrahleinrichtung 23. Die erste Laserteilstrahleinrichtung 22 und die zweite Laserteilstrahleinrichtung 23 sind in wesentlichen Teilen zueinander achsensymmetrisch, d. h. spiegelbildlich ausgebildet.

Das Herzstück jeder Laserteilstrahleinrichtung sind drei vertikal polarisierte Laserdioden 4 bzw. 4' und drei horizontal polarisierte Laserdioden 5 bzw. 5 '.

[Im Bereich vor den vertikal polarisierten Laserdioden 4 ist dabei ein erster Vertikalspiegel 9 und ein zweiter Vertikalspiegel 10 bzw. 10' vorgesehen, die die beiden entsprechenden vertikalen Lichtstrahlen 7 um einen Winkel von 90° umlenken. Dabei ist der zweite Vertikalspiegel 10 bzw. 10' gerade um einen solchen Betrag verschoben angeordnet, dass dessen zu den vertikal polarisierten Laserdioden 4 hin gerichtete Vorderkante gerade den zweiten vertikalen Lichtstrahl 7 vorbeistreichen lässt. Durch die besondere Anordnung der beiden vertikal polarisierten Laserdioden 4 im Zusammenhang mit dem ersten Vertikalspiegel 9 und dem zweiten Vertikalspiegel 10 bzw. 10' entsteht dadurch ein vertikaler Quadratlaserstrahl 13, dessen Querschnitt in der Schnittzeichnung M-M als Summe der Querschnitte der drei vertikalen Lichtstrahlen 7 veranschaulicht ist. Der vertikale Quadratlaserstrahl 13 wird in einen Polarisationswürfel 14 eingespeist. Der vertikale Quadratlaserstrahl 13 durchtritt den Polarisationswürfel 14 und tritt dort als erster Laserstrahl 16 aus. Er tritt in der Folge in einen Kollimator 19 ein.

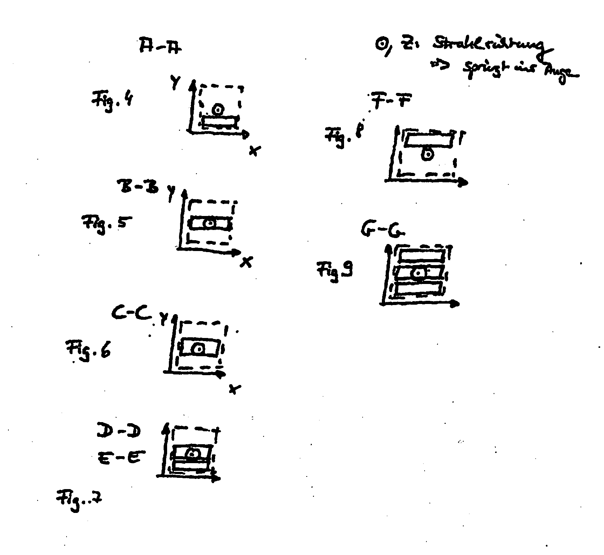

Im Wesentlichen auf dieselbe Weise werden die horizontalen Lichtstrahlen 8 aus den horizontal polarisierten Laserdioden 5 bzw. 5' in den ersten Laserstrahl 16 eingekoppelt. Hierzu ist nach der in Figur 3 linksseitig gezeigten horizontal polarisierten Laserdiode 5 ein erster Horizontalspiegel 20 vorgesehen, der den entsprechenden horizontalen Lichtstrahl 8 um 90° umlenkt. Danach ist ein zweiter Horizontalspiegel 21 vorgesehen, der den horizontalen Lichtstrahl 8 zum dritten Umlenkspiegel 27 umlenkt. Der zweite Horizontalspiegel 21 ist dabei so hoch angeordnet, dass seine untere Seite oberhalb desjenigen horizontalen Lichtstrahls 8 liegt, der aus der in Figur 3 rechts gelegenen horizontal polarisierten Laserdiode 5 austritt. Der horizontale Lichtstrahl 8, der aus der in Figur 3 rechts gelegenen horizontal polarisierten Laserdiode 5 austritt, streicht gerade unterhalb des zweiten Horizontalspiegels 21 entlang vorbei und trifft auf den dritten Umlenkspiegel 27 auf. Der Querschnitt D-D veranschaulicht dabei die Lage der beiden horizontalen Lichtstrahlen 8 kurz vor dem Auftreffen auf den dritten Umlenkspiegel 27. Entsprechend wird der Lichtstrahl 8 aus der dritten horizontalen Laserdiode 5 ' über einen vierten Umlenkspiegel 28 umgelenkt, so dass sich danach ein horizontaler Quadratlaserstrahl 29 mit einem Strahlquerschnitt G-G gemäss Figur 9 ergibt.

Der horizontale Quadratlaserstrahl 29 wird an einem ersten Umlenkspiegel 17 umgelenkt und in den Polarisationswürfel 14 eingespeist. Der horizontale Quadratlaserstrahl 29 durchtritt den Polarisationswürfel 14 und tritt dort als zusätzlicher Teil des ersten Laserstrahls 16 aus. Er tritt in der Folge in den Kollimator 19 ein.

Die in Figur 3 oben gelegenen vertikal polarisierten Laserdioden 4, 4' bilden dabei eine erste Teillasergruppe 22'. Achsensymmetrisch bzw. spiegelbildlich dazu bilden die horizontal polarisierten Laserdioden 5, 5' eine zweite Teillasergruppe 23 '.

Die Anordnungen gemäss den Figuren 1 und 2 können anstelle mit roten Laserdioden auch mit blauvioletten Laserdioden und mit grünen Laserdioden betrieben werden. Eine sehr einfache Ausführungsform für einen Betrieb mit gemischten Farben ergibt sich aus Figur 15.

Figur 15 zeigt eine schematische Darstellung einer weiteren Laservorrichtung 1' ' ' ' in der Draufsicht. Die Bauteile der Laservorrichtung 1' ' ' ' entsprechen im wesentlichen denen der Laservorrichtung 1'' in der Figur 3. Gleiche Bauteile haben dieselben Bezugsziffern. Bezugsziffern von einander entsprechenden Bauteilen haben einen Apostroph mehr als in der Figur 3. Die Laservorrichtung 1 ' ' ' gliedert sich in eine erste Laserteilstrahleinrichtung 22 sowie in eine zweite Laserteilstrahleinrichtung 23. Die erste Laserteilstrahleinrichtung 22 und die zweite Laserteilstrahleinrichtung 23 sind in wesentlichen Teilen zueinander achsensymmetrisch, d. h. spiegelbildlich angeordnet. Je nach Anforderung können auch andere Aufbauten gewählt werden.

Das Herzstück der Laserteilstrahleinrichtung 23 sind drei vertikal polarisierte rote Laserdioden 4 bzw. 4 ', deren Strahlen nebeneinander gelegt sind wie in Figur 3.

Die Laserteilstrahleinrichtung 23 ' hat horizontal polarisierte grüne Laserdiode 30 und eine horizontal polarisierte blauviolette Laserdioden 31. Deren Strahlen sind im Schema der oben dargestellten Ausführungsbeispiele jeweils mittig angeordnet. Die roten Laserdioden haben eine Wellenlänge von ca. 650 nm und eine maximale Ausgangsleistung von je ca. 90 mW.

Die grüne Laserdiode hat in diesem Ausführungsbeispiel eine Wellenlänge von ca. 532nm und eine maximale Leistung von ca. 80mW. Die blauviolette Laserdiode hat eine Wellenlänge von ca. 408nm (+- 7nm) und eine maximale Leistung von ca. 200mW.

Diese Leistungen sind jeweils Maximalleistungen. Es ist klar, dass diese innerhalb eines vorbestimmten Bereichs zur Erzielung eines gewünschten Farbtons mit einer hier nicht gezeigten Elektronik geregelt oder eingestellt werden können.

Weisslicht-Balance ergibt sich beispielsweise bei ca. 80mW grünem Licht (ca. 532 nm) und bei ca. 150mW blauviolettem Licht (ca. 408 nm), gemischt mit ca. 270 mW rotem Licht (650 nm) . Somit ergibt sich eine Gesamtleistung von ca. 600 nm, gemessen mit einem Halbleiter-Laser-Leistungsmessgerät.

Es ist klar, dass die Polarisierungen auch anders gewählt werden können, d.h. die roten Laserdioden können horizontal polarisiert sein. Die grüne und die blaue Laserdiode können auch vertikal polarisiert sein.

Der vertikale Quadratlaserstrahl 13 trifft auf einen Umlenkspiegel 32, wird dort umgelenkt und tritt in der Folge in einen Kollimator 33 ein.

Ein Lichtstrahl 34 aus der grünen Laserdiode 30 trifft auf den dritten Umlenkspiegel 27, der diesen um 90° umlenkt. Danach ist eine Sammellinse als Hilfsoptik vorgesehen.

Anschließend trifft der Lichtstrahl 34 auf einen dichroitischen Farbfilter 36 auf, der grüne Lichtstrahlen durchläset und blaue Lichtstrahlen reflektiert. Demzufolge durchtritt der grüne Lichtstrahl 34 den dichroitischen Farbfilter 36.

Ein Lichtstrahl 37 aus der blauvioletten Laserdiode 30 trifft auf den dichroitischen Farbfilter 36 auf. Demzufolge wird der wird der blauviolette Lichtstrahl 37 am dichroitischen Farbfilter 36 reflektiert und mit dem grünen Lichtstrahl 34 zu dem Cyan-Lichtstrahl 38 überlagert.

Der Cyan-Lichtstrahl 38 trifft auf einen dichroitischen Farbfilter 39 auf, der rote Lichtstrahlen durchlässt und Cyan-Lichtstrahlen reflektiert. Demzufolge wird der wird der Cyan-Lichtstrahl 38 am dichroitischen Farbfilter 39 reflektiert und mit dem durchgelassenen roten Lichtstrahl 13 zu dem weißen Lichtstrahl 41 überlagert.

Werden größere Leistungen gewünscht, dann können die roten und die blau-violetten Laserdioden erfindungsgemäß gestaffelt und deren Licht erfindungsgemäß zusammengeführt werden, beispielsweise wie in den Figuren 1 bis 3, indem man einer der Laserdioden durch eine grüne bzw. blaue Laserdiode ersetzt. Dabei sendet beispielsweise in einer Vorrichtung nach Figur 3 eine der vertikal polarisierenden Laserdioden 4 ein blauviolettes Licht aus, während die anderen vertikal polarisierendenden Laserdioden 4 und 4' rotes Licht aussenden. Einer der horizontal polarisierenden Laserdioden 5 kann dann eine grüne Laserdiode sein, wobei die anderen polarisierenden Laserdioden 5 und 5 ' rote Laserdioden sind.

Die Laservorrichtungen 1 und 1' nach Figur 1 und Figur 2 und in den Abwandlungen der Figur 1 und 2 können zur Erzeugung von Weißlicht so abgewandelt werden, dass in jeder Teillasergruppe 22, 23, 22', 23' jeweils die beiden vertikal polarisierenden Laserdioden 4 durch eine blau-violette Laserdiode und eine rote Laserdiode realisiert werden und die horizontal polarisierende Laserdioden 5 jeweils ein Paar aus einer roten und einer grünen Laserdiode aufweisen.

Noch viele andere Kombinationen der verschiedenfarbigen oder gleichfarbigen Laserdioden sind denkbar, wenn der Grundgedanke der Erfindung verwirklicht werden soll. Dazu können einzelne der oben beschriebenen roten Laserdioden durch grüne bzw. blaue Laserdioden ersetzt werden oder es werden grüne bzw. blaue Laserdioden hinzugefügt, wobei die jeweiligen Laserstrahlen mit den oben gezeigten Techniken zunächst parallel geführt und dann zusammengeführt werden, damit sie als Ausgangsstrahl eingesetzt werden können.

## Patentansprüche

1. Vorrichtung (2; 3) zur Erzeugung eines Laserstrahls (16; 16')
- mit einer horizontalen Lasereinrichtung mit zwei nebeneinander angeordneten horizontalen Laserdioden (5; 5') die jeweils einen Laserstrahl (8; 8') mit horizontal orientiertem Querschnitt erzeugen;
- mit einer vertikalen Lasereinrichtung mit zwei nebeneinander angeordneten Laserdioden (4; 4') die jeweils einen Laserstrahl (7; 7') mit vertikal orientiertem Querschnitt erzeugen;
- mit einer ersten Sammeleinheit (20, 21; 20', 21') zur Zusammenführung der beiden Laserstrahlen (8; 8') mit horizontal orientiertem Querschnitt zu einem ersten Quadratlaserstrahl;
- mit einer zweiten Sammeleinheit (9, 10; 9', 10') zur Zusammenführung der beiden Laserstrahlen (7; 7') mit vertikal orientiertem Querschnitt zu einem zweiten Quadratlaserstrahl;
- mit einer dritten Sammeleinheit (14; 14') zur Zusammenführung des ersten Quadratlaserstrahls und des zweiten Quadratlaserstrahls zu einem Ausgabelaserstrahl (16; 16'),
- wobei sich die Bezeichnungen "horizontal" und "vertikal" jeweils auf die Polarisierung des Laserstrahls beziehen,
- wobei sich der Querschnitt eines Laserstrahls aus denjenigen Orten innerhalb des Laserstrahls bestimmt, die in etwa eine gleiche Leistungsdichte aufweisen.

2. Laservorrichtung nach Anspruch 1, **dadurch gekennzeichnet, dass** die horizontale und/oder die vertikale Lasereinrichtung auf je einer Dioden-Verstelleinrichtung angeordnet ist, mit der deren Laserdioden bezüglich der übrigen Komponenten der Vorrichtung verschiebbar bzw. verdrehbar sind.

3. Laservorrichtung nach Anspruch 1 oder 2, **dadurch gekennzeichnet, dass** die Laserdioden (4, 5; 4', 5') als Halbleiter-Laserdioden ausgebildet sind, deren Substrat die Elemente P, In, Ga und/oder Al aufweist und die Licht mit einer Wellenlänge von ca. 652 nm bis 664 nm, vorzugsweise 654 nm bis ca. 662 nm und vorzugsweise mit einem Maximum bei ca. 658 nm erzeugen.

4. Laservorrichtung nach einem der vorhergehenden Ansprüche, **dadurch gekennzeichnet, dass** die Laserdioden (4, 5; 4', 5') je einen Laserstrahl (7, 8; 8, 8') mit einem im Wesentlichen elliptischen und nahezu rechteckigen Querschnitt erzeugen, wobei der Laserstrahl eine Polarisierung überwiegend in Richtung der längeren Symmetrieachse der Ellipse bzw. des Rechtecks aufweist.

5. Laservorrichtung nach einem der vorhergehenden Ansprüche, **dadurch gekennzeichnet, dass** die dritte Sammeleinheit als Polarisationswürfel (14) ausgebildet ist, der vorzugsweise aus BK7-Glas nach Grade A hergestellt ist.

6. Laservorrichtung (1) zur Erzeugung eines Laserstrahls, die
- eine erste Vorrichtung (2) nach einem der Ansprüche 1 bis 5 zur Erzeugung eines ersten Laserstrahls (16),
- eine zweite Vorrichtung (3) nach einem der Ansprüche 1 bis 5 zur Erzeugung eines zweiten Laserstrahls (25) und eine Spiegel-Kollimatoreinheit (24, 19) zur im Wesentlichen parallelen Zusammenführung und Ausgabe des ersten Laserstrahls (16) und des zweiten Laserstrahls (25) als Ausgabelaserstrahls (26) aufweist.

7. Laservorrichtung nach Anspruch 6, **dadurch gekennzeichnet, dass** die erste Laserstrahleinrichtung (2) und die zweite Laserstrahleinrichtung (3) je zwei horizontale Lasereinrichtungen (5, 20; 5', 20', 21') und zwei vertikale Lasereinrichtungen (4, 9, 10; 4', 9', 10') mit je zwei nebeneinander angeordneten Laserdioden (4, 5; 4', 5') zur Ausgabe eines horizontalen Quadratlaserstrahls bzw. eines vertikalen Quadratlaserstrahls aufweisen, wobei je eine horizontale Lasereinrichtung (5, 20, 21; 5', 20', 21') und eine vertikale Lasereinrichtung (4, 9, 10; 4', 9', 10') mit je zwei nebeneinander angeordneten Laserdioden (4, 5; 4', 5') zu einer Teillasergruppe (22; 23) angeordnet sind.

8. Laservorrichtung nach Anspruch 6 oder Anspruch 7, **dadurch gekennzeichnet, dass** je eine Teillasergruppe auf einer Teillaser-Verstelleinrichtung angeordnet ist, mit der deren Laserdioden und der Sammeleinheit gemeinsam bezüglich der übrigen Komponenten der Vorrichtung verschiebbar bzw. verdrehbar sind.

9. Laservorrichtung nach einem der Ansprüche 6 bis 8, **dadurch gekennzeichnet, dass** die Spiegel-Kollimatoreinheit einen Kollimator (19) mit einer Linseneinheit aufweist, deren eingangsseitige Brennweite größer als die ausgangsseitige Brennweite ist.

## Claims

1. Device (2; 3) for generating a laser beam (16; 16')
- with a horizontal laser device with two horizontal laser diodes (5; 5') arranged next to one another, which generate respectively a laser beam (8; 8') with a horizontally oriented cross section;
- with a vertical laser device with two laser diodes (4; 4') arranged next to one another, which generate respectively a laser beam (7; 7') with a vertically oriented cross section;
- with a first collecting unit (20, 21; 20', 21') for converging the two laser beams (8; 8') with a horizontally oriented cross section to form a first quadratic laser beam;
- with a second collecting unit (9, 10; 9', 10') for converging the two laser beams (7; 7') with a vertically oriented cross section to form a second quadratic laser beam;
- with a third collecting unit (14; 14') for converging the first quadratic laser beam and the second quadratic laser beam to form an output laser beam (16; 16'),
- wherein the terms "horizontal" and "vertical" refer respectively to the polarisation of the laser beam,
- wherein the cross section of a laser beam is determined from points within the laser beam which have approximately the same output density.

2. Laser device according to claim 1, **characterised in that** the horizontal and/or the vertical laser device is arranged on a diode adjusting device, by means of which its laser diodes can be displaced or rotated relative to the remaining components of the device.

3. Laser device according to claim 1 or 2, **characterised in that** the laser diodes (4, 5; 4', 5') are designed as semiconductor-laser diodes, the substrate of which comprises the elements P, In, Ga and/or Al and which generate light with a wavelength of about 652 nm to 664 nm, preferably 654 nm to about 662 nm and advantageously a maximum of about 658 nm.

4. Laser device according to one of the preceding claims, **characterised in that** the laser diodes (4, 5; 4', 5') each generate a laser beam (7, 8; 8, 8') with a substantially elliptical and virtually rectangular cross section, wherein the laser beam has a polarisation mostly in the direction of the longer symmetrical axis of the ellipse or the rectangle.

5. Laser device according to one of the preceding claims, **characterised in that** the third collecting unit is designed as a polarisation cube (14) which is preferably made from grade A BK7 glass.

6. Laser device (1) for generating a laser beam which comprises
- a first device (2) according to one of claims 1 to 5 for generating a first laser beam (16),
- a second device (3) according to one of claims 1 to 5 for generating a second laser beam (25) and a reflecting collimating unit (24, 19) for the substantially parallel convergence and output of the first laser beam (16) and the second laser beam (25) as an output laser beam (26).

7. Laser device according to claim 6, **characterised in that** the first laser-beam device (2) and the second laser-beam device (3) each comprise two horizontal laser devices (5, 20; 5', 20', 21') and two vertical laser devices (4, 9, 10; 4', 9', 10') with two laser diodes (4, 5; 4', 5') arranged next to one another for emitting a horizontal quadratic laser beam or a vertical quadratic laser beam, wherein a horizontal laser device (5, 20, 21; 5', 20', 21') and a vertical laser device (4, 9, 10; 4', 9', 10') with two laser diodes (4, 5; 4', 5') arranged next to one another are arranged to form a sub-laser group (22; 23).

8. Laser device according to claim 6 or claim 7, **characterised in that** a sub-laser group is arranged on a sub-laser adjusting device, by means of which its laser diodes and the collecting unit are jointly displaceable or rotatable relative to the other components of the device.

9. Laser device according to one of claims 6 to 8, **characterised in that** the reflecting collimating unit comprises a collimator (19) with a lens unit, the input-side focal distance of which is greater than the output-side focal distance.

## Revendications

1. Système (2 ; 3) destiné à générer un rayon laser (16 ; 16')
- comportant un dispositif laser horizontal avec deux diodes laser horizontales (5 ; 5') disposées côte à côte, qui génèrent chacune un rayon laser (8 ; 8') à section orientée horizontalement ;
- avec un dispositif laser avec deux diodes laser (4 ; 4') disposées côte à côte, qui génèrent chacune un rayon laser (7 ; 7') à section orientée verticalement ;
- avec une première unité collectrice (20, 21 ; 20', 21') pour le regroupement des rayons laser (8 ; 8') à section orientée horizontalement en un premier rayon laser carré ;
- avec une deuxième unité collectrice (9, 10 ; 9', 10') pour le regroupement des rayons laser (7 ; 7') à section orientée verticalement en un deuxième rayon laser carré ;
- avec une troisième unité collectrice (14 ; 14') pour le regroupement du premier rayon laser carré et du deuxième rayon laser carré en un rayon laser de sortie (16 ; 16'),
- les qualificatifs « horizontal » et « vertical » renvoyant respectivement à la polarisation du rayon laser,
- la section d'un rayon laser étant définie à partir des emplacements présentant une densité de puissance sensiblement égale à l'intérieur du rayon laser.

2. Système laser selon la revendication 1, **caractérisé en ce que** le dispositif laser horizontal et/ou le dispositif laser vertical sont montés chacun sur un dispositif de réglage de diodes au moyen duquel ses diodes laser sont translatables ou rotatives par rapport aux autres composants du système.

3. Système laser selon la revendication 1 ou la revendication 2, **caractérisé en ce que** les diodes laser (4, 5 ; 4', 5') sont réalisées comme diodes laser à semiconducteur, dont le substrat comprend les éléments P, In, Ga et/ou Al et qui génèrent de la lumière d'une longueur d'onde comprise entre environ 652 nm et 664 nm, avantageusement entre 654 nm et environ 662 nm et de préférence avec un maximum de 658 nm environ.

4. Système laser selon l'une des revendications précédentes, **caractérisé en ce que** les diodes laser (4, 5 ; 4', 5') génèrent chacune un rayon laser (7, 8 ; 8, 8') à section sensiblement elliptique et pratiquement rectangulaire, le rayon laser présentant une polarisation essentiellement dans la direction de l'axe de symétrie le plus long de l'ellipse ou du rectangle.

5. Système laser selon l'une des revendications précédentes, **caractérisé en ce que** la troisième unité collectrice est réalisée comme cube de polarisation (14) fabriqué de préférence en verre BK7 de catégorie A.

6. Système laser (1) destiné à générer un rayon laser, comportant
- un premier système (2) selon l'une des revendications 1 à 5 pour la génération d'un premier rayon laser (16),
- un deuxième système (3) selon l'une des revendications 1 à 5 pour la génération d'un deuxième rayon laser (25), et une unité miroir-collimateur (24, 19) pour le regroupement sensiblement en parallèle et la sortie du premier rayon laser (16) et du deuxième rayon laser (25) en tant que rayon laser de sortie (26).

7. Système laser selon la revendication 6, **caractérisé en ce que** le premier système à rayon laser (2) et le deuxième système à rayon laser (3) comportent chacun deux dispositifs laser horizontaux (5, 20 ; 5', 20', 21') et deux dispositifs laser verticaux (4, 9, 10 ; 4', 9', 10') avec chacun deux diodes laser (4, 5 ; 4', 5') disposées côte à côte pour la sortie d'un rayon laser horizontal carré ou d'un rayon laser vertical carré, chaque dispositif laser horizontal (5, 20, 21 ; 5', 20', 21') et chaque dispositif laser vertical (4, 9, 10 ; 4', 9', 10') étant agencé avec deux diodes laser (4, 5 ; 4', 5') disposées côte à côte pour former un groupe laser partiel (22 ; 23).

8. Système laser selon la revendication 6 ou la revendication 7, **caractérisé en ce que** chaque groupe laser partiel est monté sur un dispositif de réglage de laser partiel au moyen duquel ses diodes laser et l'unité collectrice sont translatables ou rotatives ensemble par rapport aux autres composants du système.

9. Système laser selon l'une des revendications 6 à 8, **caractérisé en ce que** l'unité miroir-collimateur comprend un collimateur (19) avec une unité lentille dont la distance focale côté entrée est supérieure à la distance focale côté sortie.
